Europäisches Patentamt

European Patent Office

Office européen des brevets

(19)

(11) Numéro de publication : **0 068 949**
**B1**

(12) **FASCICULE DE BREVET EUROPÉEN**

(45) Date de publication du fascicule du brevet :
09.10.85

(51) Int. Cl.⁴ : **G 02 F 7/00**

(21) Numéro de dépôt : 82401043.3

(22) Date de dépôt : 08.06.82

(54) **Procédé et dispositif optique de conversion analogique-numérique.**

(30) Priorité : 26.06.81 FR 8112614

(43) Date de publication de la demande :
05.01.83 Bulletin 83/01

(45) Mention de la délivrance du brevet :
09.10.85 Bulletin 85/41

(84) Etats contractants désignés :
DE GB

(56) Documents cités :
EP-A- 0 017 571
IEEE JOURNAL OF QUANTUM ELECTRONICS,
vol.QE-15, no.4, avril 1979, IEEE, New York (US) H.F.
TAYLOR: "An optical analog-to-digital converter-
Design and analysis", pages 210-216
IEEE TRANSACTIONS ON CIRCUITS AND SYSTEMS,
vol.CAS-26, no.12, décembre 1979, New York (US)
F.J. LEONBERGER et al.: "Design and development
of a high-speed electrooptic A/D converter", pages
1125-1131
APPLIED OPTICS, vol.19, no.18, septembre 1980,
New York (US) M.J. AHMED et al.: "Comparatorless
electrooptic ADC", pages 3050-3051
APPLIED OPTICS, vol.18, no.18, 15 septembre 1979,
New York (US) K. TAKIZAWA et al.: "Analog-to-digital
converter: a new type using an electrooptic light
modulator", pages 3148-3151

(73) Titulaire : **THOMSON-CSF**
**173, Boulevard Haussmann**
**F-75379 Paris Cedex 08 (FR)**

(72) Inventeur : **Le Parquier, Guy**
**THOMSON-CSF SCPI 173, bld Haussmann**
**F-75379 Paris Cedex 08 (FR)**
Inventeur : **Puech, Claude**
**THOMSON-CSF SCPI 173, bld Haussmann**
**F-75379 Paris Cedex 08 (FR)**

(74) Mandataire : **Lepercque, Jean et al**
**THOMSON-CSF SCPI 173, Bld Haussmann**
**F-75379 Paris Cedex 08 (FR)**

Jouve, 18, rue St-Denis, 75001 Paris, France

## Description

La présente invention concerne un procédé et un dispositif optique de conversion analogique-numérique.

Il est connu de réaliser un codeur analogique-numérique en utilisant des circuits électroniques. Mais les techniques de l'optique intégrée permettent la réalisation d'opérations de traitement de signal avec des performances comparables à celles de l'électronique. Ainsi il est connu de réaliser un codeur analogique-numérique utilisant les propriétés du modulateur d'amplitude en optique intégrée (Cf. « IEEE Transactions on Circuits and Systems », vol. CAS-26, n° 12, décembre 1979, pages 1125-1131). Ce modulateur d'amplitude est la version intégrée d'un interféromètre à deux ondes de type Mach-Zendler. Dans un tel interféromètre, l'intensité lumineuse transmise varie de manière sinusoïdale en fonction du déphasage créé entre les deux bras de l'interféromètre. Ce déphasage peut être obtenu en appliquant une différence de potentiel entre des électrodes placées de part et d'autre des guides d'ondes. Dans un tel codeur analogique-numérique on a autant de modulateurs que d'éléments binaires du mot de sortie ; le signal à numériser étant appliqué aux électrodes correspondant respectivement à tous ces modulateurs.

Lorsque l'on considère un système à codage Gray, ceci impose la même précision absolue pour chaque transition, donc une précision relative d'autant plus grande que l'élément binaire du mot de sortie est de plus fort poids. Ceci peut être une limitation de dynamique.

Le procédé de l'invention qui utilise les propriétés du modulateur d'amplitude optique intégrée n'a pas cette limite.

L'invention a pour objet un procédé optique de conversion analogique-numérique dans un codeur comprenant n voies correspondant aux n éléments binaires du mot numérique de sortie, chaque voie comportant au moins un modulateur d'intensité lumineuse comprenant à la surface d'un substrat en matériau électrooptique un interféromètre à deux bras, l'intensité du rayonnement émerge étant fonction du déphasage introduit par application d'une différence de potentiel entre des électrodes disposées à la surface du substrat à proximité d'au moins l'un des bras de l'interféromètre, l'une des différences de potentiel représentative du signal à numériser V(t) étant appliquée à tous les interféromètres aux bornes d'électrodes dont la longueur est telle que pour la voie i : $L_i = 2^{i-2}L^2$ ; i pouvant varier de 2 à n et $L_2$ étant la longueur des électrodes pour la voie 2, la voie 1 correspondant à l'élément binaire 1 qui est l'élément de plus fort poids du mot de sortie, caractérisé en ce, que pour chaque voie i, lorsque le signal de sortie de la voie i + 1 est positif par rapport à son niveau moyen, on introduit un déphasage supplémentaire + Δφ au signal de sortie de cette voie i, en appliquant une différence de potentiel aux bornes d'électrodes correspondant à au moins l'un des bras du modulateur correspondant à cette voie i, et lorsque le signal de sortie de la voie i + 1 est négatif par rapport à son niveau moyen, on introduit un déphasage supplémentaire − Δφ au signal de sortie de cette voie i, en appliquant une différence de potentiel aux bornes d'électrodes correspondant à au moins l'un des bras du modulateur correspondant à cette voie i, ce déphasage Δφ étant tel que : $/\Delta\phi < \pi/2$.

L'invention a, en outre, pour objet un dispositif mettant en œuvre ce procédé.

D'autres caractéristiques et avantages de l'invention apparaîtront mieux à l'aide de la description ci-après et des figures annexées parmi lesquelles :

— la figure 1 représente un codeur analogique-numérique de l'art connu ;

— les figures 2 et 3 représentent deux types de modulateurs optiques de l'art connu ;

— la figure 4 est un diagramme illustrant le fonctionnement des modulateurs des figures 2 et 3 ;

— la figure 5 représente le dispositif de l'invention ;

— les figures 6 à 9 sont des diagrammes illustrant le fonctionnement du dispositif de l'invention ;

— les figures 10 à 12 représentent une partie du dispositif de l'invention ;

— la figure 13 est un diagramme illustrant la variante de la figure 11 ;

— la figure 14 est un exemple de schéma électrique partiel du dispositif de l'invention.

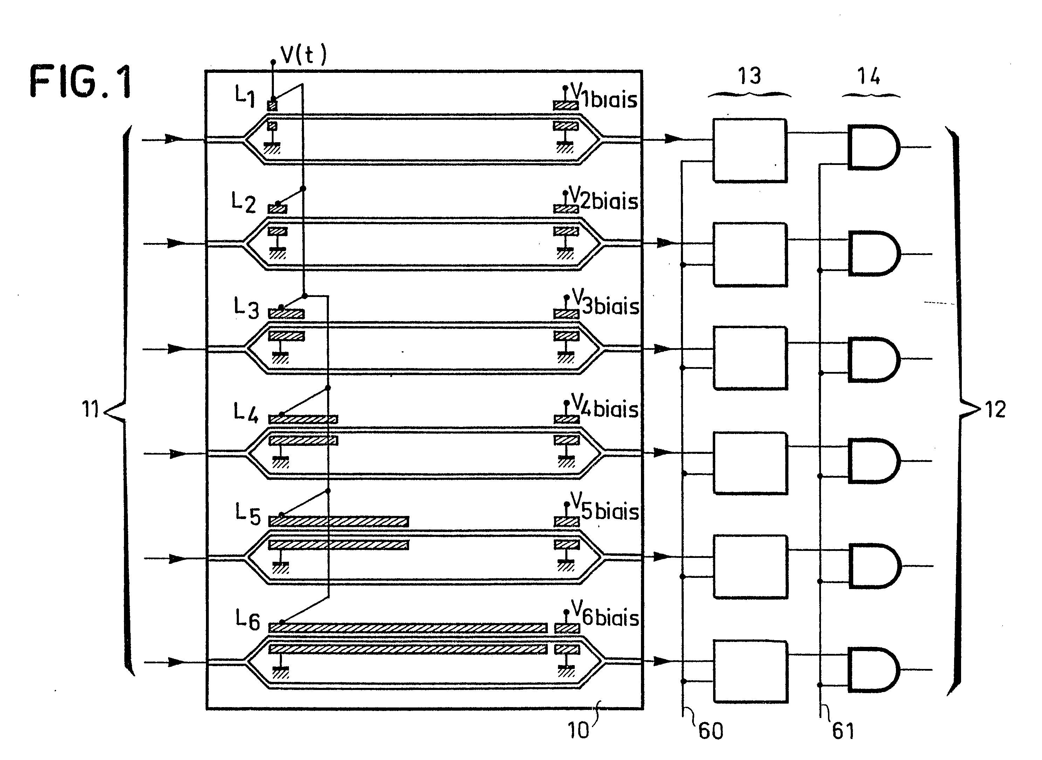

La structure du codeur analogique-numérique réalisé en optique intégrée de l'art connu est représentée en figure 1. Elle est réalisée à partir d'éléments de base comportant un modulateur d'intensité lumineuse réalisé avec un interféromètre à deux bras.

Une onde lumineuse 11 produite par une source laser est présentée à l'entrée de ce dispositif qui comporte six voies comprenant chacune un modulateur optique élémentaire intégré sur un substrat 10. A chaque modulateur correspondant donc un élément binaire du mot de sortie.

Le signal à numériser S(t) est appliqué à des électrodes appartenant à chacun de ces modulateurs optiques élémentaires. La longueur de ces électrodes est différente. On a une longueur $L_1$ pour le modulateur de la voie 1, et $L_2$, $L_3$, $L_4$, $L_5$ et $L_6$ pour les autres voies de numéros 2, 3, 4, 5 et 6. on règle ainsi le déphasage entre les deux ondes qui arrivent dans le guide de sortie et donc la période du signal $I_S = f(\Delta\phi')$.

Pour notamment le code binaire pur et le code Gray on considère la relation $L_i = 2^{i-2}L_2$ avec i variant de 2 à n, avec n = 6, ici ; en effet la période du signal représentatif de l'élément binaire i du mot numérique de sortie est le double de celle du signal représentatif du signal i + 1. La voie 1 correspond à l'élément binaire de plus fort poids.

Dans le cas du code Gray $L_1 = L_2$, par contre dans le cas du code binaire pur $L_2 = 2 L_1$.

On peut considérer des tensions de biais que l'on appelera $V_{ibiais}$ appliquées aux modulateurs de ces différentes voies ; ces tensions permettant d'introduire sur un bras un déphasage fixe ou « biais ».

Ces différentes tensions $V_{ibiais}$ permettent de compenser les chemins optiques dans les deux bras de chaque modulateur optique élémentaire intégré sur le substrat 10. En effet, ces chemins optiques ne peuvent être de longueurs rigoureusement égales par construction. Elles permettent ainsi d'introduire des déphasages supplémentaires en cas notamment d'utilisation de code Gray.

Dans ce cas, le passage d'une valeur numérique à la suivante se fait par la modification d'un seul élément binaire du mot numérique ce qui évite les aléas de transitions multiples ; on pourrait tout aussi bien envoyer un signal $S(t) + V_{ibiais}$ sur une seule électrode, chaque interféromètre ne comportant donc plus qu'une seule électrode de longueur $L_i$ déterminée.

En sortie de ces modulateurs on place des photodétecteurs suivis de comparateurs représentés en 13 qui en fonction de la valeur fixe référence 60 permettent d'obtenir à leur sortie des valeurs 0 ou 1, cette valeur fixe référence 60 est représentative de l'intensité maximale divisée par 2 : $I_{SM}/2$.

A la sortie, les portes ET 14 permettent une validation du signal de sortie à un certain moment. Cette validation peut tenir compte du temps de transit dans ces modulateurs ; lorsque l'on utilise, par exemple, en entrée 11 un laser à impulsions, cela permet un échantillonnage dans le temps. On obtient ainsi un mot binaire en parallèle. On a mesuré le temps de réponse d'un tel codeur analogique-numérique, il est inférieur à 0,5 nanoseconde.

Sur cette figure 1 on considère une électrode de longueur $L_i$ disposée sur un bras, mais il est aussi possible d'appliquer la tension $V(t)$ sur les deux bras. Dans ce cas on double la valeur du déphasage. Ainsi pour éviter d'allonger les bras des modulateurs en même temps que les électrodes on peut appliquer une tension $V(t)$, puis $2V(t)$ mais une limite en tension existe du fait de la tension de claquage qui est d'environ 40 Volts pour une distance interélectrodes de 4 à 5 micromètres pour une épaisseur de guide d'environ 2 micromètres. Une autre limite apparaît du fait de la différence qui doit exister entre l'indice du guide et celui du substrat : on a, de ce fait, une valeur maximum de 30 Volts.

Mais dans ce dispositif illustré à la figure 1, dans le cas d'utilisation d'un code Gray notamment, on doit obtenir la même précision absolue pour chaque transition, donc une précision relative d'autant plus grande que l'élément binaire du mot numérique est de plus fort poids, ce qui est une cause de limitation de dynamique.

Dans la suite on considèrera les signaux à la sortie des comparateurs ; ce sont donc des signaux variant autour d'une valeur moyenne nulle.

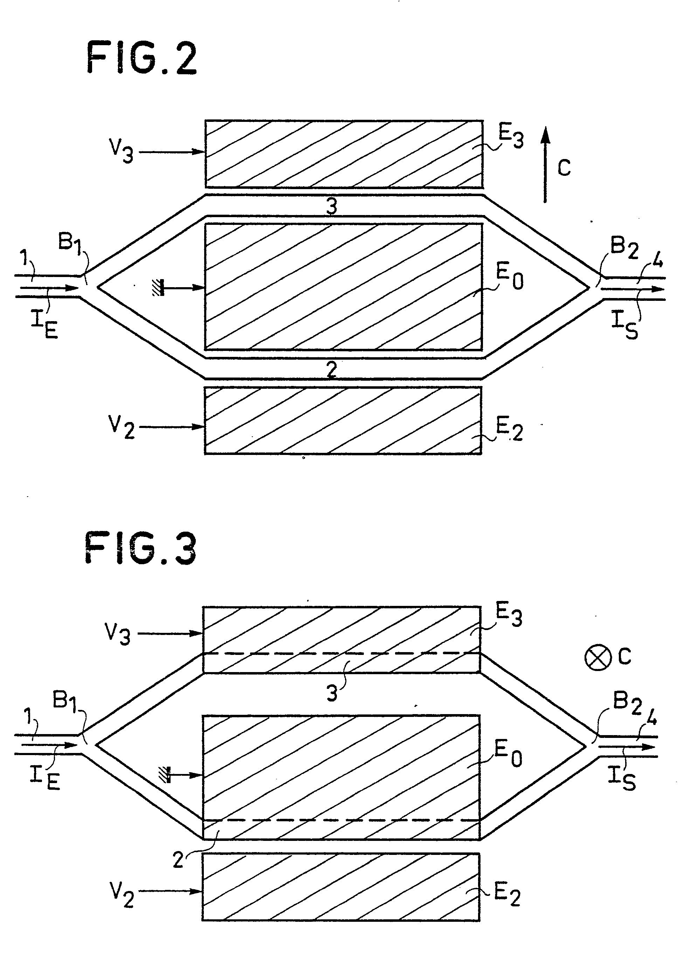

On peut voir sur la figure 2 le schéma d'un tel interféromètre à deux bras permettant de moduler l'intensité lumineuse $I_E$. Cet interféromètre comprend une branche de guide d'onde d'entrée 1 monomode dans laquelle est couplée une onde lumineuse d'intensité $I_E$. Cette branche 1 se sépare à la bifurcation $B_1$ en deux bras parallèles 2 et 3 constituant des guides monomodes, qui se rejoignent en une bifurcation $B_2$ pour former une branche de guide d'onde de sortie monomode 4 où l'on peut récupérer une intensité $I_S$. Les directions de propagation dans les quatre guides sont les mêmes. En réalité cet interféromètre à deux bras possède deux sorties. En effet quand les signaux sont en opposition de phase, la lumière se propage à l'intérieur du substrat ; ce qui revient à exciter le mode supérieur qui ne se propage pas dans le guide mais qui fuit dans le substrat. Des électrodes sont disposées de part et d'autre de chacun des guides 2 et 3, par exemple une électrode centrale $E_0$, une électrode $E_2$ de l'autre côté du bras 2 et à laquelle on applique une tension $V_2$ et une électrode $E_3$ de l'autre côté du bras 3 à laquelle on applique une tension $V_3$, l'électrode $E_0$ étant reliée à la masse. La disposition des électrodes telle que représentée sur la figure 2, c'est-à-dire ne recouvrant pas les guides mais leur étant adjacents, provoque dans chacun des guides 2 et 3 des champs électriques perpendiculaires à la direction de propagation des ondes lumineuses et dans le plan de la figure. Dans ce cas, le mode de propagation utilisé dans les guides est un mode TE. L'ensemble du dispositif est réalisé à la surface d'un substrat possédant des propriétés électrooptiques, tel que le niobate de lithium ($LiNbO_3$), le tantalate de lithium ($LiTaO_3$) ou l'arséniure de gallium (GaAs). Dans un substrat de Niobate de lithium par exemple, les guides d'onde optique sont obtenus par diffusion de titane. Cette diffusion est sélective grâce à des procédés de photolithographie classique. Dans le cas de la figure 1 où les champs électriques appliqués aux guides sont dans le plan de la figure, il est préférable que l'axe c du niobate de lithium soit également dans ce plan et perpendiculaire à la direction de propagation commune aux guides 1 à 4, de façon à présenter l'effet électrooptique maximal. Si les tensions $V_2$ et $V_3$ sont de même signe, les champs provoquent des variations dans les vitesses de propagation des ondes lumineuses pour chacun des deux guides : la tension $V_3$ provoque une variation en sens inverse — $\Delta\beta_2$ qui lui est également proportionnelle. Ces variations de vitesse provoquent à l'emplacement de la bifurcation $B_2$ un déphasage entre les deux ondes issues des guides 2 et 3 qui se trouvaient primitivement en phase à la bifurcation $B_1$. Ce déphasage $\Delta\phi$ est égal à $\Delta\beta_3L_3 + \Delta\beta_2L_2$ où $L_2$ et $L_3$ sont les longueurs des électrodes comprises entre les deux bifurcations $B_1$ et $B_2$. En général $L_2 = L_3 = L$, si bien que $\Delta\phi' = (\Delta\beta_3 + \Delta\beta_2)L$. Bien entendu, l'une des deux tensions $V_2$ ou $V_3$ peut être nulle, si bien que seule la variation $\Delta\beta_3$

ou $\Delta\beta_2$ intervient. On peut mettre l'expression du déphasage $\Delta\phi$ sous la forme $\pi(V_3 + V_2)/V\pi$ où $V\pi$ est la somme des tensions qui provoquent un déphasage $\Delta\phi$ égale à $\pi$. Les ondes lumineuses récupérées dans le guide 4 résultent de la combinaison des ondes issues des guides 2 et 3 arrivant dans la bifurcation $B_2$ c'est-à-dire deux ondes d'intensité $I_E/2$ déphasées l'une par rapport à l'autre de $\Delta\phi$. On peut donc écrire l'intensité résultante $I_S$ sous la forme $\alpha$ $(I_E/2)$ $(1 + M \cos \Delta\phi) = \alpha$ $(I_E/2)$ $[1 + M \cos (\pi(V_3 + V_2/V\pi))]$ où $\alpha$ et M sont des constantes qui dépendent des pertes de couplage et de la dissymétrie de l'interféromètre. On aboutit à un résultat semblable avec une seule paire d'électrodes par exemple $E_0$ et $E_3$. Dans ce cas $\Delta\beta_2 = 0$ et $I_S = \alpha(I_e/2)$ $[1 + M \cos (\pi V_3/V\pi)]$.

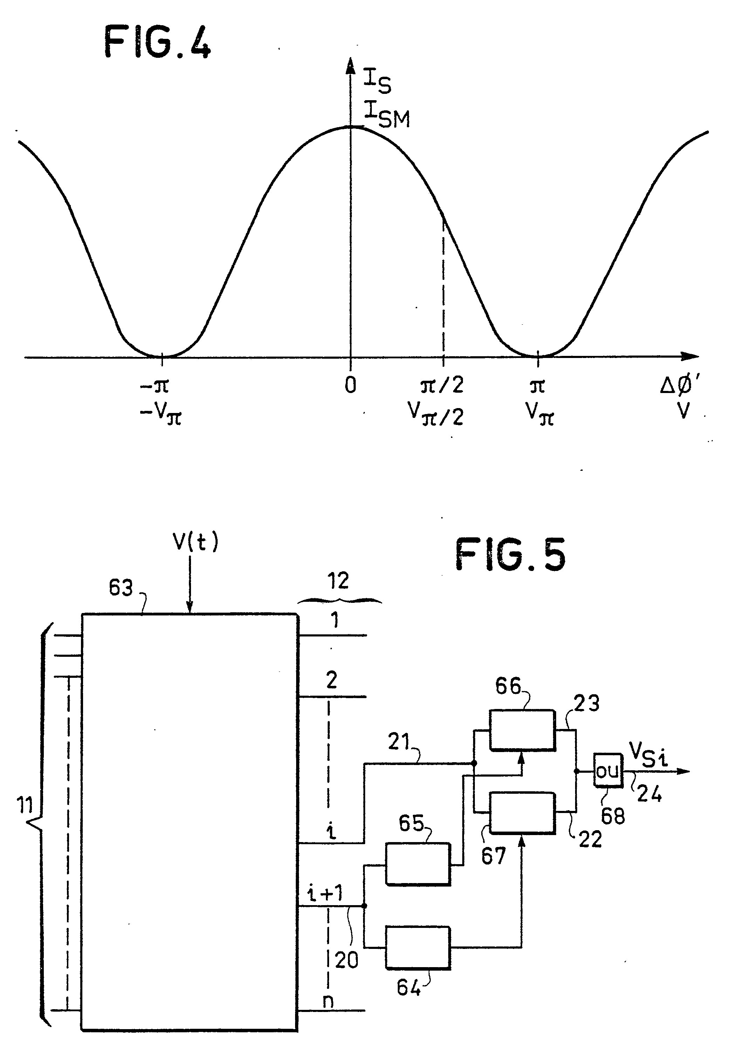

La figure 3 représente elle aussi le schéma d'un interféromètre à deux bras. Mais cette fois-ci les électrodes $E_3$ et $E_0$ sont déposées à la surface du substrat au-dessus des deux guides 2 et 3. La disposition de ces électrodes provoque dans chacun de ces guides 2 et 3 des champs perpendiculaires à la propagation des ondes lumineuses, et perpendiculaires au plan de la figure. Il est préférable alors que l'axe C du niobate de lithium soit également perpendiculaire à la direction de propagation commune aux guides 1 à 4, et perpendiculaire au plan de la figure.

La figure 4 est la courbe représentative de l'intensité émergente $I_S$ relative aux deux types d'interféromètre représentés aux figures 2 et 3, en fonction du déphasage $\Delta\phi$ existant à l'emplacement de la bifurcation $B_2$, ou de la tension V égale à la tension (ou à la somme des tensions) appliquée à l'une au moins des électrodes $E_2$ et $E_3$, prise avec son (leur) signe par rapport à la masse. Lorsque V est nul, l'intensité de sortie $I_S$ est maximale et vaut $I_{SM}$. Lorsque V est nul, l'intensité de sortie $I_S$ est maximale et vaut $I_{SM}$. Lorsque la valeur absolue de V augmente, l'intensité lumineuse $I_S$ diminue et la valeur minimale $I_m$ est obtenue pour $V = V\pi$, cette valeur $I_m$ est théoriquement nulle comme représentée sur la figure 4. Au voisinage de $V\pi/2$, la variation de $I_S$ peut être considérée, au premier ordre, comme linéaire en fonction de $\Delta\phi$ ou de V. Toutefois le taux d'harmoniques de la variation de $I_S$ en fonction de $V - (V\pi/2)$ croît très rapidement lorsqu'on s'éloigne de $V\pi/2$.

Dans la suite on considérera des interféromètres du type illustré à la figure 2, mais il est tout aussi possible de considérer des interféromètres du type illustré à la figure 3.

Il est également possible de scinder en deux parties les électrodes 2 et 3. Une partie de la longueur de chaque bras de l'interféromètre peut être aussi soumise à un champ modulant provenant d'une première tension $V_M$ tandis que l'autre partie est soumise à un champ modulant provenant d'une deuxième tension $V_R$. Ce sont des interféromètres de ce type qui ont été considérés à la figure 1.

Le fait d'appliquer des champs électriques de même intensité et de sens opposés aux deux bras 2 et 3 de l'interféromètre permet d'augmenter la sensibilité du modulateur, c'est-à-dire de diminuer les tensions modulantes nécessaires pour obtenir un déphasage donné.

L'invention concerne un codeur analogique-numérique de même structure que celui illustré à la figure 1 utilisant comme élément de base le modulateur d'amplitude optique intégré tel que décrit précédemment. Mais le procédé utilisé permet de palier le problème mentionné plus haut à savoir le lever d'ambiguïté.

Le dispositif permettant d'utiliser le procédé selon l'invention est illustré à la figure 5. On considère alors les modulateurs correspondant aux poids $2^{-i}$ et $2^{-(i+1)}$, avec i compris entre 1 et n.

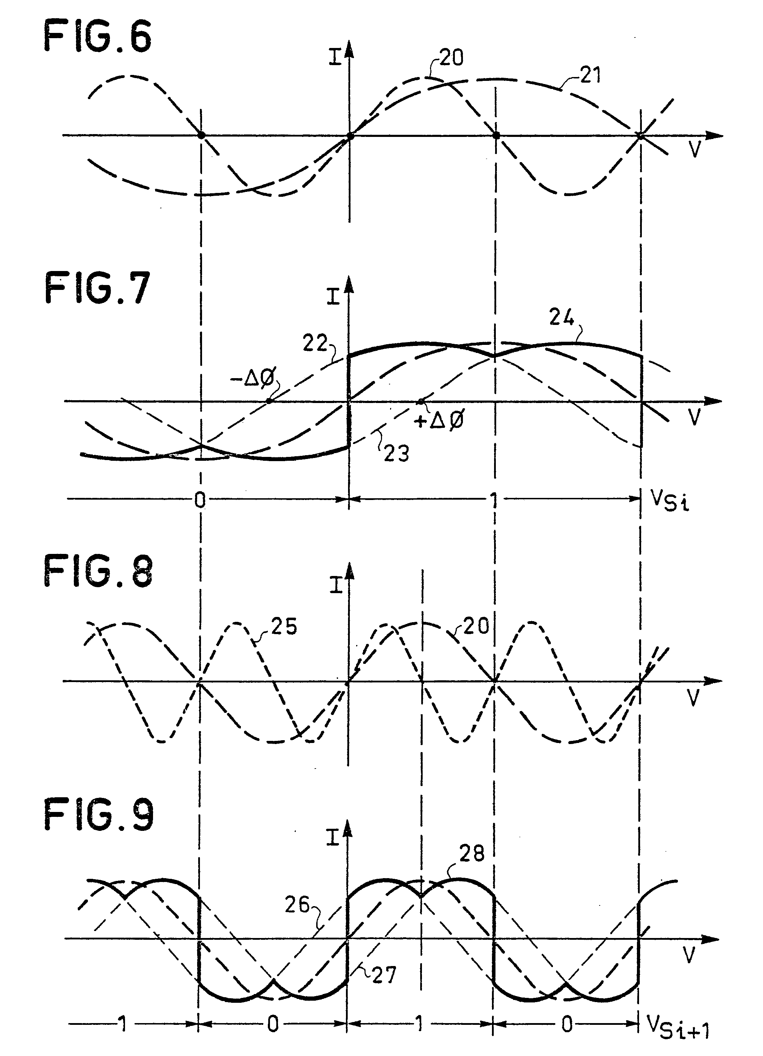

Dans le dispositif de l'art connu les signaux de sorties correspondants présentés passent par leur niveau moyen simultanément une fois sur deux comme cela est représenté à la figure 6.

Pour ne pas faire d'erreur sur l'élément binaire i, il faut que la précision sur le passage à zéro et le gain de l'amplificateur associé soit deux fois meilleur que pour l'élément binaire $i + 1$. Ceci est rédhibitoire pour la rapidité, le ·nombre d'éléments binaires du mot de sortie du codeur et les tolérances de fabrication.

Pour pallier ce problème on utilise le procédé illustré à la figure 7, en considérant les circuits de la figure 5.

Lorsque le signal 20 correspondant à l'élément binaire $i + 1$ est positif, ce qui est détecté en 64, on déplace les passages à zéro du signal 21 correspondant à l'élément binaire i, ce qui est représenté en 67, en introduisant un déphasage $+ \Delta\phi$ qui peut être par exemple de $+ \pi/4$. On obtient un nouveau signal correspondant à l'élément binaire i, soit 22 ce signal.

Lorsque le signal 20 correspondant à l'élément binaire $i + 1$ est négatif, on déplace les passages à zéro du signal correspondant à l'élément binaire i en introduisant un déphasage supplémentaire $- \Delta\phi$ par exemple de $- \pi/4$. On obtient un nouveau signal correspondant à l'élément binaire i, soit 23 ce signal.

Le déphasage supplémentaire $\Delta\phi$ est tel que $/\Delta\phi/ < \pi/2$.

Ainsi sur le signal 21 correspondant à l'élément binaire est remplacé en sortie par le signal résultant 24 tracé en trait fort sur la figure 7. Ce signal est formé par les parties du signal 22 et du signal 23, tel que cela vient d'être décrit, après une porte OU 28.

Les incertitudes sur les niveaux de commutation sont alors levées puisque c'est le signal 20 correspondant à l'élément binaire $i + 1$ qui les impose.

On voit en effet que les alternances positives successives du signal 20 correspondant à l'élément binaire $i + 1$ tombent en phase avec les alternances positives puis négatives du signal 22 qui est une partie du signal résultant 24 tracé en trait fort. De même, les alternances successives négatives du signal correspondant à l'élément binaire $i + 1$ sont en phase ou en opposition de phase avec les alternances positives ou négatives du signal 23 qui est une partie du signal résultant 24 tracé en trait fort. Cette manière de procéder permet de forcer la décision.

On considère aux figures 8 et 9 la même façon de procéder mais avec les signaux correspondants aux éléments binaires i + 1 et i + 2 soient les signaux 20 et 25.

On obtient le signal 26 correspondant au signal précédent 22 et le signal 27 correspondant au signal précédent 23.

Ce qui permet d'obtenir le signal résultant 28 en trait fort qui vient remplacer en sortie du codeur le signal 20.

On appelera de façon générale par la suite les signaux 22 ou 26 qui sont décalés de − Δφ par rapport au signal représentant le i ou i + 1 : signal B, et les signaux 23 ou 27 décalés de + Δφ : signal A.

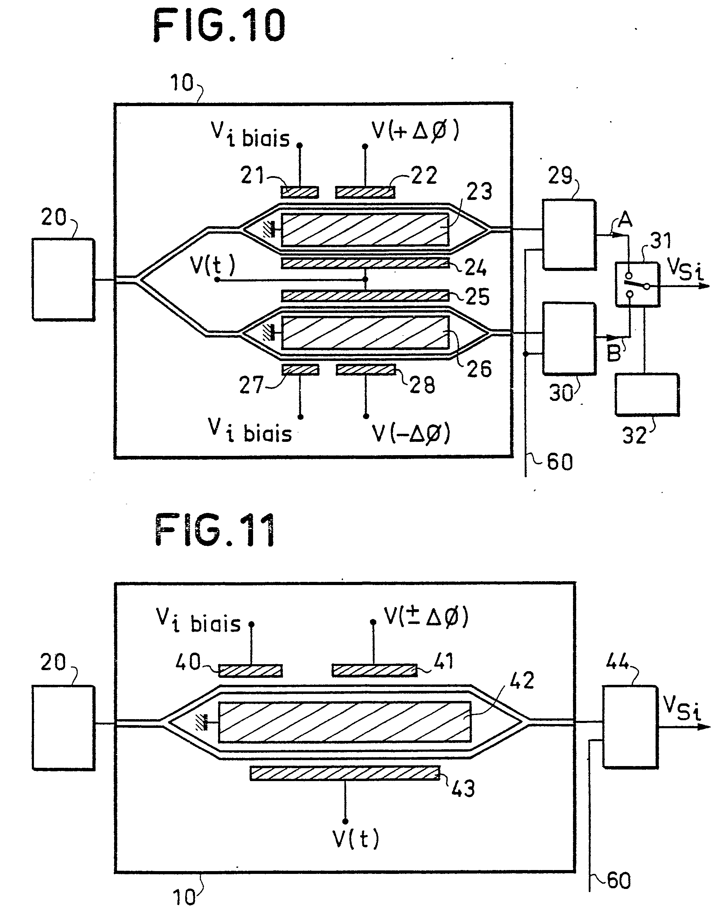

Plusieurs modes de réalisation du circuit optique intégré correspondant à un élément binaire du mot de sortie peuvent être envisagés. L'élément de base demeure le modulateur d'amplitude optique intégré sur les électrodes duquel est appliqué le signal à numériser plus une tension complémentaire assurant des déphasages de + Δφ ou − Δφ, Δφ étant égal par exemple à $\pi/4$. Il peut exister aussi comme dans le cas illustré à la figure 5, des tensions de biais $V_{ibiais}$ pour compenser les différences existant entre les chemins optiques, ou pour introduire des déphasages complémentaires tel que dans le cas d'utilisation du code Gray. Un premier mode de réalisation est représenté sur la figure 10 : le rayonnement issu du laser est couplé simultanément dans deux modulateurs identiques. La tension appliquée sur les électrodes du premier (du second) est la tension à numériser plus une tension assurant un déphasage supplémentaire de + Δφ (de − Δφ). Le premier modulateur engendre le signal A, le second le signal B. Les sorties A et B correspondant aux deux voies sont commutées en 31 par un signal logique provenant de l'étage i + 1 représenté en 32. Les photodétecteurs suivis de comparateurs sont représentés en 29 et 30.

Ce principe étant parfaitement valable pour des éléments binaires de rangé : avec i de 1 à n, on voit que seule la précision du codeur de rang le plus élevé est importante, les autres ne servant qu'à la levée d'ambiguïté. Un second mode de réalisation illustré à la figure 11 consiste à n'utiliser qu'un seul modulateur d'amplitude sur les électrodes duquel, en plus de la tension à numériser est appliquée une tension assurant un déphasage de + Δφ ou − Δφ selon l'information donnée par l'étage i + 1, le photodétecteur suivi du comparateur est représenté en 44.

Ainsi dans le cas du codeur optique intégré, les n éléments binaires du mot de sortie sont disponibles en parallèle.

Dans cette nouvelle configuration de codeur, les différents éléments binaires sont connus les uns après les autres, l'élément binaire le plus significatif étant connu en dernier. En supposant un temps de réponse de 1 nanoseconde par étage, le fait que la réponse pour l'élément binaire i, nécessite de connaître le bit (i + 1), fait que le temps de réponse total est de n nanosecondes pour un codeur à n éléments binaires soit de l'ordre de 6 nanosecondes pour un codeur de 6 éléments binaires du mot de sortie, et ce temps de transit n'est pas rédhibitoire pour la plupart des applications.

On peut d'ailleurs, introduire des lignes à retard dans la logique correspondante de ces éléments binaires, ce qui permet de rétablir par exemple le débit de 1 nanoseconde par mot de sortie, ceci quel que soit le nombre d'étages.

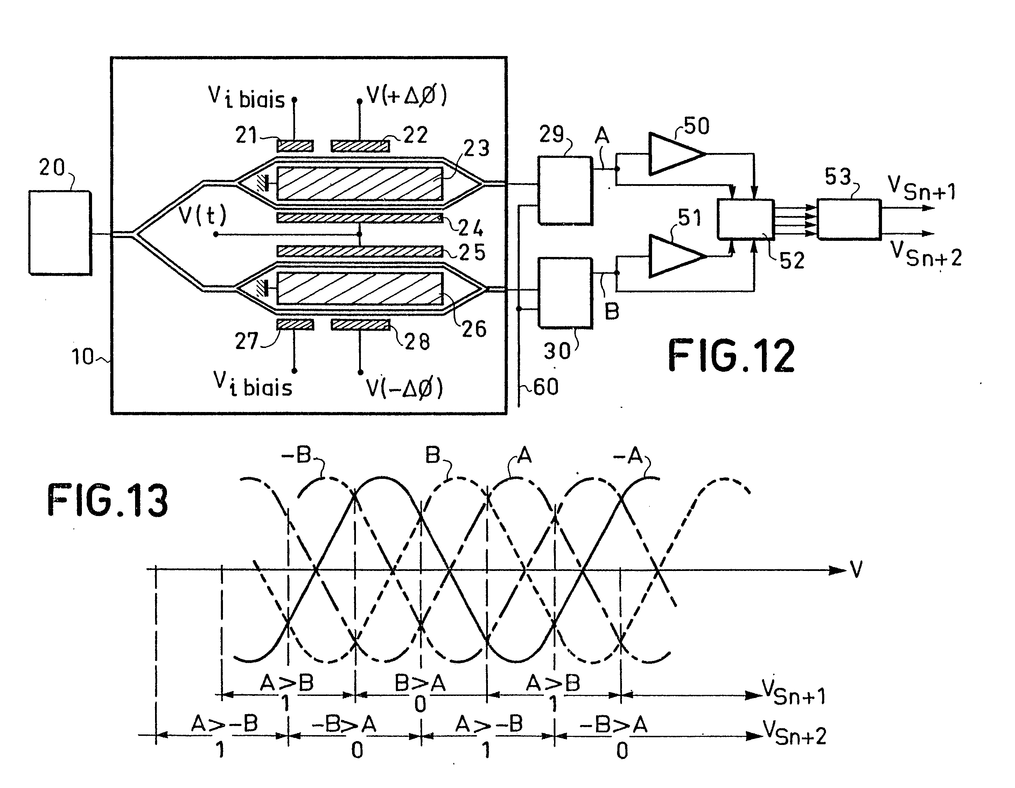

Une modification du circuit, correspondant à l'élément binaire de plus faible poids, est illustrée à la figure 12. Elle permet d'adjoindre deux éléments binaires supplémentaire de précision. En effet on peut ainsi obtenir les signaux A, B, − A, − B ; − A et − B étant les signaux en opposition de phase avec les signaux A et B. On obtient une information supplémentaire du cadran dans lequel se trouve la sinusoïde. Par un transcodage on obtient deux éléments binaires du mot de sortie. L'un Sn + 1 correspond à la comparaison de A et de B et l'autre Sn + 2 à la comparaison de A et de − B comme représenté à la figure 13.

Cette figure 12 correspond à la figure 10 à laquelle on a apporté quelques modifications. Les circuits 50 et 51 permettent d'obtenir les signaux − A et − B. En sortie du circuit 52 on a les signaux A, B, − A, − B et en sortie du circuit 53 on a les signaux correspondant aux deux éléments binaires supplémentaires : Sn + 1 et Sn + 2.

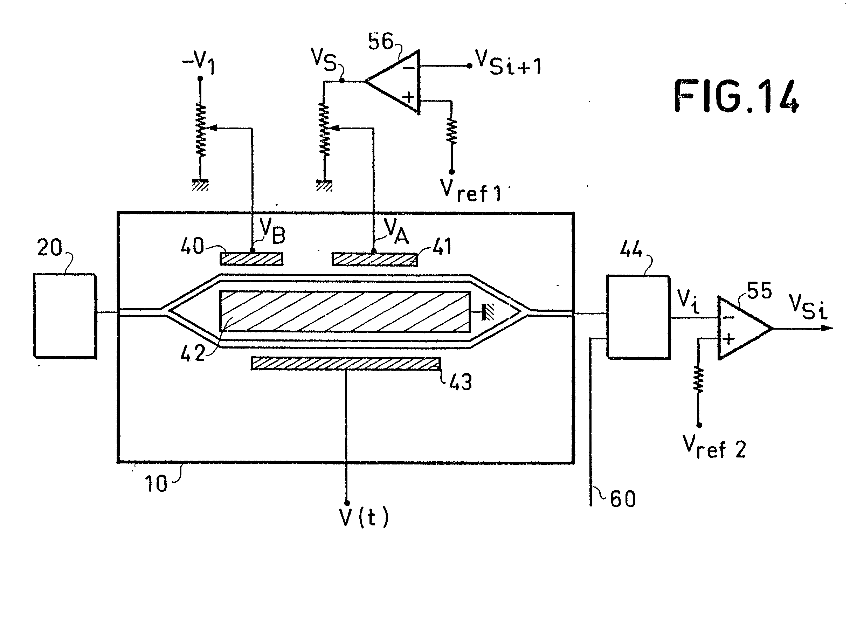

La figure 14 représente une réalisation concrète du dispositif précédemment décrit et illustré à la figure 10.

Sur l'électrode de biais 40 est appliquée une tension $V_B$ introduisant un déphasage de − Δφ.

Le signal $V_{Si+1}$ issu de l'élément binaire i + 1 est soit 0 si l'élément binaire est 0, soit V si l'élément binaire est 1. Il est envoyé dans un comparateur 56 sur lequel est entré une tension référence $V_{réf1}$.

Si $V_{i+1} < V_{réf1}$, $V_s \sim 0 \Rightarrow$ la tension $V_A$ appliquée sur l'électrode de 41 est peu différente de 0 : $V_A \sim 0 \Rightarrow$ déphasage nul.

Si $V_{i+1} V_{réf1}$, $V_s \neq 0 \Rightarrow$ la tension $V_A$ appliquée sur l'électrode 41 est telle que le déphasage soit 2 Δφ.

Ainsi si l'élément binaire i + 1 est 0 : $V_B + V_A \Rightarrow$ déphasage de − Δφ si l'élément binaire i + 1 est 1 : $V_B + V_A \Rightarrow$ de + Δφ.

L'électronique de détection placée à la sortie du guide comprend :

— un photodétecteur suivi d'un amplificateur représentés en 44 de manière à ajuster la tension $V_i$ ;

— un comparateur 55.

La tension $V_i$ issue de l'amplificateur est comparée à une tension référence $V_{réf2}$ :
Si $V_i < V_{réf2} \Rightarrow V_i = 0$.
Si $V_i > V_{réf2} \Rightarrow V_i = 1$.

## Revendications

1. Procédé optique de conversion analogique-numérique dans un codeur comprenant n voies correspondant aux n éléments binaires du mot numérique de sortie, chaque voie comportant au moins un modulateur d'intensité lumineuse comprenant à la surface d'un substrat (10) en matériau électrooptique un interféromètre à deux bras, l'intensité du rayonnement émergent étant fonction du déphasage introduit par application d'une différence de potentiel entre des électrodes disposées à la surface du substrat à proximité d'au moins l'un des bras de l'interféromètre, l'une des différences de potentiel représentative du signal à numériser V(t) étant appliquée à tous les interféromètres aux bornes d'électrodes dont la longueur est telle que pour la voie i : $L_i = 2^{i-2}L_2$, i pouvant varier de 2 à n et $L_2$ étant la longueur des électrodes pour la voie 2, la voie 1 correspondant à l'élément binaire 1 qui est l'élément de plus fort poids du mot de sortie, caractérisé en ce que, pour chaque voie i, lorsque le signal de sortie de la voie i + 1 est positif par rapport à son niveau moyen, on introduit un déphasage supplémentaire + $\Delta\phi$ au signal de sortie de cette voie i, en appliquant une différence de potentiel aux bornes d'électrodes correspondant à au moins l'un des bras du modulateur correspondant à cette voie i, et lorsque le signal de sortie de la voie i + 1 est négatif par rapport à son niveau moyen, on introduit un déphasage supplémentaire − $\Delta\phi$ au signal de sortie de cette voie i, en appliquant une différence de potentiel aux bornes d'électrodes correspondant à au moins l'un des bras du modulateur correspondant à cette voie i, ce déphasage étant tel que /$\Delta\phi$/< $\pi$/2.

2. Dispositif, pour la mise en œuvre du procédé optique selon la revendication 1, de conversion analogique-numérique dans un codeur comprenant n voies correspondant aux n éléments binaires du mot numérique de sortie, chaque voie comportant au moins un modulateur d'intensité lumineuse comprenant à la surface d'un substrat (10) en matériau électrooptique un interféromètre à deux bras, des électrodes étant disposées à la surface du substrat à proximité d'au moins l'un des bras de l'interféromètre ; dispositif caractérisé en ce qu'il comporte pour chaque voie des moyens de détection des alternances positives et négatives par rapport à leur niveau moyen des signaux de sortie du codeur, ces moyens, pour la voie i + 1 étant couplés à des moyens permettant de créer un déphasage + $\Delta\phi$ ou − $\Delta\phi$ sur le signal de sortie de la voie i de rang immédiatement inférieur, i étant compris entre 1 et n ; et en ce que le codage numérique considéré est un codage Gray, les électrodes $L_1$ et $L_2$ correspondant aux voies 1 et 2 étant égales.

3. Dispositif selon la revendication 2, caractérisé en ce que l'interféromètre et les guides sont réalisés sur l'une des faces du substrat (10) par création de zones dans lesquelles l'indice de réfraction est supérieur à celui du substrat.

4. Dispositif selon la revendication 3, caractérisé en ce que le substrat est en niobate de lithium, l'interféromètre et les guides étant obtenu par diffusion localisée de titane.

5. Dispositif selon la revendication 2, caractérisé en ce que les différences de potentiel sont appliquées respectivement aux deux bras de l'interféromètre et sont obtenus entre une première électrode et respectivement une deuxième et une troisième électrodes, ces trois électrodes étant disposées de façon que des tensions électriques appliquées respectivement aux deuxième et troisième électrodes et ayant la même polarité par rapport à la première électrode produisent dans les deux bras des champs électriques de sens opposés.

6. Dispositif selon la revendication 5, caractérisé en ce que les trois électrodes sont disposées de façon à être adjacentes aux bras de l'interféromètre, la première étant placée de part et d'autre de l'interféromètre, de façon à créer dans les bras des champs électriques parallèles à la surface du substrat (10).

7. Dispositif selon la revendication 5, caractérisé en ce que la première électrode est placée entre les deux bras de façon à recouvrir sélective-ment l'un des bras, la deuxième électrode étant placée de façon à être adjacente à ce bras, la troisième électrode étant placée de façon à recouvrir l'autre bras, de façon à créer dans les guides des champs électriques perpendiculaires à la surface du substrat (10).

8. Dispositif selon l'une quelconque des revendications 3 à 7, caractérisé en ce que le substrat (10) est orienté de façon que son axe C soit parallèle aux champs électriques créés dans les guides.

9. Dispositif suivant la revendication 2, caractérisé en ce que chaque voie du codeur comprend deux modulateurs optiques ; une différence de potentiel étant appliquée à l'un de leur bras pour créer successivement un déphasage de + $\Delta\phi$ et de − $\Delta\phi$ ; un détecteur suivi d'un comparateur étant disposé à la sortie de chacun de ces modulateurs, un commutateur permettant de sélectionner le signal de sortie de l'un de ces deux comparateurs en fonction des alternances positive ou négative de signal représentant l'élément binaire i + 1 de poids immédiatement inférieur à l'élément binaire i.

10. Dispositif suivant la revendication 2, caractérisé en ce qu'à chaque voie correspond un modulateur optique ; une différence de potentiel étant appliquée aux bornes de l'un de ses bras pour créer successivement un déphasage de + $\Delta\phi$ et de − $\Delta\phi$ en fonction des alternances positive ou négative du signal représentant l'élément binaire i + 1 de poids immédiatement inférieur à l'élément binaire i ; ce modulateur étant suivi d'un photodétecteur et d'un comparateur.

11. Dispositif suivant l'une quelconque des revendications précédentes, caractérisé en ce que pour la voie n, de plus faible poids, on génère deux nouveaux éléments binaires de sortie en comparant le signal de sortie décalé de + $\Delta\phi$ avec

le signal de sortie décalé de − Δφ, et avec leurs signaux en opposition de phase.

**Claims**

1. Optical analog-digital conversion method in a coder comprising n channels corresponding to the n binary elements of the digital output word, each channel comprising at least one luminous intensity modulator comprising an interferometer with two arms at the surface of a substrate (10) of electrooptic material, the intensity of the emerging radiation being a function of the phase shift introduced by the application of a potential difference between electrodes disposed at the substrate surface in the neighbourhood of at least one of the arms of the interferometer, one of the potential differences representing the signal V(t) to be digitized being applied to all of the interferometers at their electrode terminals the length of which is such that for the channel i: $L_i = 2^{i-2}L_2$, i being susceptible to vary between 2 and n and $L_2$ being the length of the electrodes for the channel 2, the channel 1 corresponding to the binary element 1 which is the most significant element of the output word, characterized in that, for each channel i, when the output signal of the channel i + 1 is positive with respect to its mean level, an additional phase shift + Δφ is introduced in the output signal of this channel i by applying a potential difference to the electrode terminals corresponding to at least one of the arms of the modulator corresponding to this channel i, and when the output signal of the channel i + 1 is negative with respect to its mean level, an additional phase shift − Δφ is introduced in the output signal of this channel i by applying a potential difference to the electrode terminals corresponding to at least one of the arms of the modulator corresponding to this channel i, the phase shift being such that /Δφ/< π/2.

2. Device for performing the optical method according to claim 1, for the analog-digital conversion in a coder comprising n channels corresponding to n binary elements of the digital output word, each channel comprising at least one luminous intensity modulator comprising an interferometer with two arms at the surface of a substrate (10) of electrooptic material, electrodes being disposed at the surface of the substrate in the neighbourhood of at least one of the arms of the interferometer ; the device being characterized in that it comprises for each channel detection means for detecting the positive and negative alternations with respect to their mean levels of the output signals of the coder, these means, for the channel i + 1, being coupled to means permitting to introduce a phase shift + Δφ or − Δφ in the output signal of the channel i of immediately less significance, i being comprised between 1 and n ; and in that the considered digital coding is a Gray coding, the electrodes $L_1$ and $L_2$ corresponding to the channels 1 and 2 being equal.

3. Device according to claim 2, characterized in that the interferometer and the guides are embodied on one of the faces of the substrate (10) by generating zones wherein the index of refraction is larger than that of the substrate.

4. Device according to claim 3, characterized in that the substrate is of lithium niobate, the interferometer and the guides being obtained by localized titanium diffusion.

5. Device according to claim 2, characterized in that the potential differences are respectively applied to the two arms of the interferometer and are obtained between a first and second and third electrodes, respectively, these three electrodes being disposed in such a manner that the electric voltages applied respectively to the second and third electrodes and having the same polarity with respect to the first electrode produce electric fields of opposite senses within the two arms.

6. Device according to claim 5, characterized in that the three electrodes are disposed in such a manner that they lie adjacent to the arms of the interferometer, the first being placed on both sides of the interferometer in a manner to generate within the arms electric fields extending parallel to the surface of the substrate (10).

7. Device according to claim 5, characterized in that the first electrode is placed between the two arms in such a manner that it selectively covers one of the arms, the second electrode being placed in such a manner that it lies adjacent to this arm, the third electrode being placed in such a manner that it covers the other arm in a manner to generate electric fields perpendicular to the surface of the substrate (10) within the guides.

8. Device according to any of claims 3 to 7, characterized in that the substrate (10) is oriented in such a manner that its axis C is parallel to the electric fields generated within the guides.

9. Device according to claim 2, characterized in that each channel of the coder comprises two optical modulators ; a potential difference being applied to one of their arms to generate successively a phase shift of + Δφ and of − Δφ ; a detector followed by a comparator being disposed at the output of each of the modulators, a switch permitting to select the output signal of one of these two comparators as a function of positive or negative alternations of this signal representing the binary element i + 1 of immediately less significance than the binary element i.

10. Device according to claim 2, characterized in that one optical modulator corresponds to each channel ; a potential difference being applied to the terminals of one of its arms to introduce successively a phase shift of + Δφ and of − Δφ in function of the positive or negative alternations of the signal representing the binary element i + 1 of immediately less significance than the binary element i ; this modulator being followed by a photodetector and a comparator.

11. Device according to any of the preceding claims, characterized in that for the channel n of least significance, two new binary output elements are generated by comparing the output signal shifted by $+\Delta\phi$ with the output signal shifted by $-\Delta\phi$, and with their signals of opposite phase.

**Patentansprüche**

1. Optisches Verfahren zur Analog/Digital-Umsetzung in einem Kodierer, der n Kanäle enthält, welche den n Binärelementen des digitalen Ausgangswortes entsprechen, wobei jeder Kanal wenigstens einen Lichtintensitätsmodulator aufweist, der an der Oberfläche eines Substrats (10) aus elektrooptischem Material ein Interferometer mit zwei Zweigen aufweist, wobei die austretende Strahlungsintensität von der Phasenverschiebung abhängt, welche durch Anlegen einer Potentialdifferenz zwischen Elektroden eingeführt wird, die an der Oberfläche des Substrats in der Nähe wenigstens eines Zweiges des Interferometers angeordnet sind, wobei eine der Potentialdifferenzen, die das zu digitalisierende Signal V(t) darstellt, an die Elektrodenanschlüsse aller Interferometer angelegt wird, wobei die Länge dieser Elektroden derart ist, daß für den Kanal $i : L_i = 2^{i-2}L_2$, worin i zwischen 2 und n variiert und $L_2$ die Länge der Elektroden für den Kanal 2 ist, während der Kanal 1 dem Binärelement 1 entspricht, welches das Element größter Wertigkeit in dem Ausgangswort ist, dadurch gekennzeichnet, daß für jeden Kanal i, wenn das Ausgangssignal des Kanals i + 1 positiv gegenüber seinem Mittelwert ist, eine zusätzliche Phasenverschiebung $+\Delta\phi$ beim Ausgangssignal dieses Kanals i eingeführt wird, indem eine Potentialdifferenz angelegt wird an die Elektrodenanschlüsse, welche wenigstens einem der Zweige des diesem Kanal i entsprechenden Modulators entsprechen, und wenn dieses Ausgangssignal des Kanals i + 1 negativ gegenüber seinem Mittelwert ist, so wird eine zusätzliche Phasenverschiebung $-\Delta\phi$ im Ausgangssignal dieses Kanals i eingeführt, indem eine Potentialdifferenz angelegt wird an die Elektrodenanschlüsse, die wenigstens einem der Zweige des Modulators entsprechen, welcher diesem Kanal i entspricht, wobei diese Phasenverschiebung derart ist, daß $/\Delta\phi/ < \pi/2$ beträgt.

2. Vorrichtung zur Durchführung des optischen Verfahrens nach Anspruch 1, zur Analog/Digital-Umsetzung in einem Kodierer, der n Kanäle enthält, welche den n Binärelementen des digitalen Ausgangswortes entsprechen, wobei jeder Kanal wenigstens einen Lichtintensitätsmodulator umfaßt, der an der Oberfläche eines Substrats (10) aus elektrooptischem Material ein Interferometer mit zwei Zweigen aufweist, wobei Elektroden an der Oberfläche des Substrates in der Nähe wenigstens eines Zweiges des Interferometers angeordnet sind ; wobei die Vorrichtung dadurch gekennzeichnet ist, daß sie für jeden Kanal Detektionsmittel zur Erfassung der positiven und negativen Halbschwingungen in bezug auf ihren Mittelwert der Ausgangssignale des Kodierers umfaßt, wobei diese Mittel für den Kanal i + 1 an Mittel angekoppelt sind, die es gestatten, eine Phasenverschiebung $+\Delta\phi$ oder $-\Delta\phi$ in dem Ausgangssignal des Kanals i mit nächstkleinerer Ordnungszahl einzuführen, wobei i zwischen 1 und n beträgt ; und daß die betreffende digitale Kodierung eine Gray-Kodierung ist, wobei die Elektroden $L_1$ und $L_2$, welche den Kanälen 1 und 2 entsprechen, gleich sind.

3. Vorrichtung nach Anspruch 2, dadurch gekennzeichnet, daß das Interferometer und die Leiter auf einer der Flächen des Substrats (10) gebildet sind durch Herstellung von Zonen, in welchen der Brechungsindex größer als der des Substrates ist.

4. Vorrichtung nach Anspruch 3, dadurch gekennzeichnet, daß das Substrat aus Lithiumniobat besteht, wobei das Interferometer und die Leiter durch örtliche Diffusion von Titan erhalten sind.

5. Vorrichtung nach Anspruch 2, dadurch gekennzeichnet, daß die Potentialdifferenzen jeweils an zwei Zweigen des Interferometers angelegt werden und zwischen einer ersten Elektrode sowie einer zweiten bzw. dritten Elektrode erhalten werden, wobei diese drei Elektroden derart angeordnet sind, daß elektrische Spannungen, die jeweils an die zweite und dritte Elektrode angelegt werden und dieselbe Polarität in bezug auf die erste Elektrode aufweisen, in den zwei Zweigen elektrische Felder von entgegengesetztem Sinn erzeugen.

6. Vorrichtung nach Anspruch 5, dadurch gekennzeichnet, daß die drei Elektroden derart angeordnet sind, daß sie angrenzend an die Zweige des Interferometers liegen, wobei die erste auf der einen bzw. anderen Seite des Interferometers derart angeordnet ist, daß sie in den Zweigen elektrische Felder parallel zur Substratoberfläche (10) erzeugt.

7. Vorrichtung nach Anspruch 5, dadurch gekennzeichnet, daß die erste Elektrode zwischen den zwei Zweigen derart angeordnet ist, daß sie selektiv einen der Zweige bedeckt, wobei die zweite Elektrode derart angeordnet ist, daß sie an diesen Zweig angrenzt, und wobei die dritte Elektrode derart angeordnet ist, daß sie den anderen Zweig bedeckt, so daß in den Leitern elektrische Felder senkrecht zur Substratoberfläche (10) erzeugt werden.

8. Vorrichtung nach einem der Ansprüche 3 bis 7, dadurch gekennzeichnet, daß das Substrat (10) derart orientiert ist, daß seine Achse C parallel zu den in den Leitern erzeugten elektrischen Feldern ist.

9. Vorrichtung nach Anspruch 2, dadurch gekennzeichnet, daß jeder Kanal des Kodierers zwei optische Modulatoren umfaßt ; wobei eine Potentialdifferenz an einen ihrer Zweige angelegt wird, um nacheinander eine Phasenverschiebung von $+\Delta\phi$ und $-\Delta\phi$ zu erzeugen ; wobei ein Detektor, auf den ein Komparator folgt, am Ausgang jedes dieser Modulatoren angeordnet ist und ein Umschalter es gestattet, das Ausgangssignal eines der zwei Komparatoren in Abhängigkeit von positiven oder negativen Halbschwingungen des Signals auszuwählen, welches das Binärelement i + 1 von nächstniedrigerer Wertigkeit als das Binärelement i darstellt.

10. Vorrichtung nach Anspruch 2, dadurch gekennzeichnet, daß jedem Kanal ein optischer Modulator entspricht ; wobei eine Potentialdifferenz an die Anschlüsse eines seiner Zweige angelegt wird, um nacheinander eine Phasenverschiebung von $+ \Delta\phi$ und $- \Delta\phi$ zu erzeugen, in Abhängigkeit von den positiven oder negativen Halbschwingungen des Signals, welches das Binärelement i + 1 von nächstniedrigerer Wertigkeit als das Binärelement i darstellt ; wobei auf diesen Modulator ein Photodetektor und ein Komparator folgen.

11. Vorrichtung nach einem der vorstehenden Ansprüche, dadurch gekennzeichnet, daß für den Kanal n von geringster Wertigkeit zwei neue Ausgangsbinärelemente erzeugt werden, indem das um $+ \Delta\phi$ verschobene Ausgangssignal mit dem um $- \Delta\phi$ verschobenen Ausgangssignal und mit ihren Signalen entgegengesetzter Phasenlage verglichen wird.

FIG.1

0 068 949

# FIG.2

# FIG.3

# FIG.4

# FIG.5

FIG.6

FIG.7

FIG.8

FIG.9

# FIG.10

# FIG.11

5

FIG.12

FIG.13

FIG.14